(19) **Europäisches Patentamt / European Patent Office / Office européen des brevets**

(11) **EP 2 196 558 A1**

(12) # EUROPEAN PATENT APPLICATION
published in accordance with Art. 153(4) EPC

(43) Date of publication:
**16.06.2010 Bulletin 2010/24**

(21) Application number: **06797277.8**

(22) Date of filing: **01.09.2006**

(51) Int Cl.:
*C23C 16/34* [(2006.01)]        *H01L 21/203* [(2006.01)]
*H01L 21/318* [(2006.01)]

(86) International application number:
**PCT/JP2006/317335**

(87) International publication number:
**WO 2007/026876 (08.03.2007 Gazette 2007/10)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **01.09.2005 JP 2005254156**

(71) Applicant: **Canon Anelva Corporation**
**Asao-ku**
**Kawasaki-shi**
**Kanagawa 215-8550 (JP)**

(72) Inventors:
• **JUN, Keeyoung**
**Yokohama-shi, Kanagawa 236-8515 (JP)**

• **OOBA, Yoshiyuki**
**Yokohama-shi, Kanagawa 236-8515 (JP)**
• **SAKAMOTO, Hitoshi**
**Yokohama-shi, Kanagawa 236-8515 (JP)**
• **OGURA, Yuzuru**
**Yokohama-shi, Kanagawa 236-8515 (JP)**
• **SEKINE, Takayuki**
**Yokohama-shi, Kanagawa 236-8515 (JP)**

(74) Representative: **Musker, David Charles**
**R.G.C. Jenkins & Co**
**26 Caxton Street**
**London SW1H 0RJ (GB)**

(54) **THIN LAYER FORMATION EQUIPMENT AND PROCESS FOR FORMATION OF THIN LAYERS**

(57)    A thin AlN layer can be formed without fail under low-temperature conditions by a process which comprises feeding a chlorine containing working gas (17) into a chamber (1), forming $NH_2$ which is a compound composed of nitrogen and hydrogen, etching an Al member (11) to be etched with chlorine radicals under the conditions of enhanced internal pressure of the chamber (1) and prolonged residence time to form a precursor $AlCl_3$ from Al contained in the member (11) and Cl with the conversion of the $AlX_3$ into an intermediate $AlX_2$, and depositing AlN formed by the reaction between the $NH_2$ and the $AlX_2$ on a substrate (3).

*FIG. 1*

**Description**

**TECHNICAL FIELD**

The present invention relates to a thin-film producing apparatus which can form a film of an AlN component, and to a method of producing a thin film.

**BACKGROUND ART**

At present, in a field of manufacturing a semiconductor or the like, a film-forming method with the use of a plasma CVD (Chemical Vapor Deposition) apparatus is known. The plasma CVD apparatus is an apparatus for depositing a metal thin film or the like, by converting a gas of an organometallic complex or the like which is a material of the film and has been introduced in a chamber, into a plasma state by using a high-frequency wave that is incident from a high-frequency antenna, and by promoting a chemical reaction on the surface of a substrate by an active excited atom in the plasma.

In contrast, the present inventors developed a plasma CVD apparatus (hereinafter referred to as a new type of plasma CVD apparatus) and a film-forming method (see following Patent Document 1, for instance), which are followed. In the plasma CVD apparatus and the film-forming method, an etching object member made from a metal component that forms a high-vapor-pressure halide, and is expected to form a film, is provided in a chamber, a halogen gas converted into a plasma state to etch above described etching object member by the radical of halogen, thereby generating a precursor of a halide of the metal component, and simultaneously only the metal component of the precursor deposit on the substrate.

The above described new type of the plasma CVD apparatus is structured so as to form the metal film on the substrate by controlling the temperature of the substrate to be lower than that of the etching object member to be a source of a metal to be deposited, at a predetermined low pressure (0.1 Torr to 0.2 Torr, for instance). For instance, when the metal of the etching object member is represented by M, and a halogen gas is represented by $Cl_2$, a thin film of M can be formed on the above described substrate by controlling the etching object member to a high temperature (300°C to 700°C, for instance), and controlling the substrate to a low temperature (approximately 200°C, for instance). This process is considered to be caused by the following reactions.

(1) dissociation reaction of plasma; $Cl_2 \rightarrow 2Cl^*$
(2) etching reaction; $M + Cl^* \rightarrow MCl$ (g)
(3) adsorption reaction onto substrate; $MCl$ (g) $\rightarrow MC1$ (ad)
(4) deposition reaction; $MCl$ (ad) $+ Cl^* \rightarrow M + Cl_2 \uparrow$
Here, $Cl^*$ represents a radical of Cl, (g) represents a gas state, and (ad) represents an adsorbed state respectively.

The above described new type of the CVD apparatus appropriately keeps a ratio of MCl to $Cl^*$ to make a deposition reaction appropriately proceed. Specifically, a flow rate of $Cl_2$ gas, a pressure, a power, temperatures of the substrate and the etching object member, a distance between the substrate and the etching object member, and the like as film-forming conditions are appropriately set, and thereby the ratio of MCl and $Cl^*$ can be controlled to be approximately the same, and M is detected without lowering a film-forming speed, and besides, without making $Cl^*$ excessively etch the substrate.

It is considered to prepare a thin film of aluminum nitride (AlN) to be used for a semiconductor material or the like, by using the above described new type of the CVD apparatus. In the case of using Al for the etching object member, MCl in the reaction formula becomes $AlX_3$. However, $AlX_3$ is stable, so that it is difficult to cause the etching (reducing) reaction due to $Cl^*$, under present circumstances. For this reason, the compatibility with a raw material of nitrogen or the like is also important, and such a technology has not been established as to unfailingly produce the thin film of AlN in the new type of the CVD apparatus.

Patent Document 1: Japanese Patent Application Laid-Open No. 2003-147534

**DISCLOSURE OF THE INVENTION**

The present invention is designed with respect to the above described circumstances, and the object is to provide a thin-film producing apparatus and a method of producing the thin film which can unfailingly produce a thin film of AlN with the use of a new type of a CVD apparatus.

In order to achieve the above described object, a thin-film producing apparatus of the present invention according to claim 1 comprises a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; forming means for forming $NH_2$ which is a compound of nitrogen and hydrogen, in the inner part of the chamber; and a controlling means for generating a intermediate product of $AlX_2$ from the precursor $AlX_3$ by lowering temperature of the substrate side less than temperature of the etching object member and simultaneously controlling the staying period of fluid, and forming AlN component generated from reaction of the $NH_2$ generated by the forming means and the $AlX_2$, on the substrate side.

Thus, the thin-film producing apparatus controls the staying period of the fluid to form the intermediate product of $AlX_2$, makes the AlN component which has been produced through the reaction of $NH_2$ with $AlX_2$ form its film on the substrate side, accordingly facilitates a reduction by the halogen radical, and can unfailingly produce a thin film of AlN at low temperatures.

In order to achieve the above described object, a thin-film producing apparatus of the present invention according to claim 2 comprises: a chamber configured to accommodate a substrate therein; an etching object member containing Al configured to provide at a position opposing to the substrate in the chamber; action gas feeding means for feeding an action gas containing a halogen into the inside of the chamber; a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical; forming means for forming $NH_2$ which is a compound of nitrogen and hydrogen, in the inner part of the chamber; and a controlling means for generating a intermediate product of AlX from the precursor $AlX_3$ by lowering temperature of the substrate side less than temperature of the etching object member and simultaneously controlling the staying period of fluid, and forming AlN component generated from reaction of the $NH_2$ generated by the forming means, the AlX, and the halogen radical, on the substrate side.

Thus, the thin-film producing apparatus controls the staying period of the fluid to form the intermediate product of AlX, makes the AlN component which has been produced through the reaction of $NH_2$ with AlX form its film on the substrate side, accordingly facilitates a reduction by the halogen radical, and can unfailingly produce a thin film of AlN at low temperatures.

The thin-film producing apparatus of the present invention according to claim 3 is **characterized in that** the forming means has a function of making ammonia ($NH_3$) react with the halogen radical to form $NH_2$, in the thin-film producing apparatus according to claim 1.

Thus, the thin-film producing apparatus can form $NH_2$ by using ammonia ($NH_3$).

The thin-film producing apparatus of the present invention according to claim 4 is **characterized in that** the forming means has a function of converting ammonia ($NH_3$) into $NH_2$ and a H radical in the plasma to form $NH_2$, in the thin-film producing apparatus according to claim 1.

Thus, the thin-film producing apparatus can form $NH_2$ by using ammonia ($NH_3$).

The thin-film producing apparatus of the present invention according to claim 5 is **characterized in that** the forming means has a function of causing a dissociation reaction between hydrogen and nitrogen thereby to form $NH_2$, in the thin-film producing apparatus according to claim 1.

Thus, the thin-film producing apparatus can form $NH_2$ by using hydrogen and nitrogen.

The thin-film producing apparatus of the present invention according to claim 6 is **characterized in that** the forming means includes a function of adjusting an amount of $NH_2$ according to a state of the precursor $AlX_3$, and the control means includes a function of adjusting an amount of $NH_2$ to a desired state to make the Al component and the A1N component intermixed on the substrate, in the thin-film producing apparatus according to claim 1.

Thus, the thin-film producing apparatus adjusts the amount of $NH_2$ to the desired state, and thereby can produce the thin film in which the Al component and the AlN component are intermixed, on the substrate.

The thin-film producing apparatus of the present invention according to claim 7 is **characterized in that** the function of the control means for making the Al component and the AlN component intermixed is a function of alternately stacking the Al component and the AlN component on each other, in the thin-film producing apparatus according to claim 6.

Thus, the thin-film producing apparatus can produce the thin film in which the Al component and the AlN component are alternately stacked on each other.

The thin-film producing apparatus of the present invention according to claim 8 is **characterized in that** the staying period is derived from a value calculated by dividing the volume of the chamber by a product of a flow rate of the action gas, a temperature in the atmosphere and a pressure in the chamber, and the plasma generating means and the control means control the staying period by increasing the pressure in the chamber, in the thin-film producing apparatus according to claim 1.

Thus, the thin-film producing apparatus increases the pressure in the chamber, and thereby can form the film of the A1N component on the substrate side.

The thin-film producing apparatus of the present invention according to claim 9 is **characterized in that** the halogen contained in the action gas is chlorine, in the thin-film producing apparatus according to claim 1.

Thus, inexpensive chlorine can be used.

In order to achieve the above described object, a method of producing a thin film of the present invention according to claim 10 comprises: forming $NH_2$ which is a compound of nitrogen and hydrogen, while feeding an action gas containing a halogen into a chamber; etching an etching object member containing Al with a halogen radical by controlling a staying period of a fluid to form a precursor $AlX_3$ formed by an Al component contained in the etching object member and the halogen X; and forming an AlN component which has been produced through a reaction of $NH_2$ with $AlX_2$ on a substrate side, while producing an intermediate product of $AlX_2$ from the precursor $AlX_3$.

Thus, the method of producing the thin film controls the staying period of the fluid to form the intermediate product of $AlX_2$, makes the AlN component which has been produced through the reaction of $NH_2$ with $AlX_2$ form its film on the substrate side, accordingly facilitates a reduction by the halogen radical, and can unfailingly produce a thin film of AlN at low temperatures.

In order to achieve the above described object, a method of producing a thin film of the present invention according to claim 11 comprises: forming $NH_2$ which is a compound of nitrogen and hydrogen, while feeding an action gas containing a halogen into a chamber; etching an etching object member containing Al with a halogen radical by controlling a staying period of a fluid to form a precursor $AlX_3$ formed by an Al component contained in the etching object member and the halogen X; and forming an AlN component which has been produced through a reaction of $NH_2$ with $AlX_2$ and the halogen radical on a substrate side, while producing an intermediate product of $AlX_2$ from the precursor $AlX_3$.

Thus, the method of producing the thin film controls the staying period of the fluid to form the intermediate product of AlX, makes the AlN component which has been produced through the reaction of $NH_2$ with AlX form its film on the substrate side, accordingly facilitates a reduction by the halogen radical, and can unfailingly produce a thin film of AlN at low temperatures.

The method of producing the thin film of the present invention according to claim 12 is **characterized in that** the method of producing the thin film according to claim 10 includes making ammonia ($NH_3$) react with the halogen radical to form $NH_2$.

Thus, the method of producing the thin film can produce a thin film of AlN by using ammonia ($NH_3$).

The method of producing the thin film of the present invention according to claim 13 is **characterized in that** the method of producing the thin film according to claim 10 includes converting ammonia ($NH_3$) into $NH_2$ and a H radical in plasma to form $NH_2$.

Thus, the method of producing the thin film can produce a thin film of AlN by using ammonia ($NH_3$).

The method of producing the thin film of the present invention according to claim 14 is **characterized in that** $NH_2$ in the method of producing the thin film according to claim 10 includes causing a dissociation reaction between hydrogen and nitrogen to form $NH_2$.

Thus, the thin film of AlN can be produced by using hydrogen and nitrogen.

The method of producing the thin film of the present invention according to claim 15 is **characterized in that** the method of producing the thin film according to claim 10 includes adjusting an amount of $NH_2$ according to a state of the precursor $AlX_3$, and producing the thin film on the substrate, in which the Al component and the AlN component are intermixed.

Thus, the thin-film producing apparatus adjusts the amount of $NH_2$ to the desired state, and thereby can produce the thin film in which the Al component and the AlN component are intermixed, on the substrate.

The method of producing the thin film of the present invention according to claim 16 is **characterized in that** the method of producing the thin film according to claim 15 includes producing the thin film in which the Al component and the AlN component are alternately stacked on each other, by making the Al component and the AlN component intermixed.

Thus, the method of producing the thin film can produce the thin film in which the Al component and the AlN component are alternately stacked on each other.

The method of producing the thin film of the present invention according to claim 17 is **characterized in that** the method of producing the thin film according to claim 15 includes producing the thin film in which the AlN component and the Al component are alternately stacked on each other by making the Al component and the AlN component intermixed, on the substrate on which the thin film of $Al_2O_3$ has been produced.

Thus, the method of producing the thin film can produce a thin film in which an AlN component and an Al component are stacked, on the substrate on which the thin film of $Al_2O_3$ was produced, which can be a gate metal having a high dielectric constant.

The method of producing the thin film of the present invention according to claim 18 is **characterized in that** the halogen contained in the action gas is chlorine, in the method of producing the thin film according to claim 10.

Thus, inexpensive chlorine can be used.

A thin-film producing apparatus according to the present invention is a thin-film producing apparatus which can unfailingly produce a thin film of AlN at low temperatures by using a new type of a CVD apparatus. In addition, a method of producing a thin film according to the present invention is a method of producing a thin film, which can unfailingly produce a thin film of AlN in an environment of a low temperature by using a new type of a CVD apparatus.

## BRIEF DESCRIPTION OF THE DRAWINGS

FIG. 1 is a schematic side view of a thin-film producing apparatus according to one embodiment of the present invention; and
FIG. 2 is a graph showing a light-emitting state of plasma.

## BEST MODES FOR CARRYING OUT THE INVENTION

Embodiments according to the present invention will now be described in detail below with reference to the drawings.

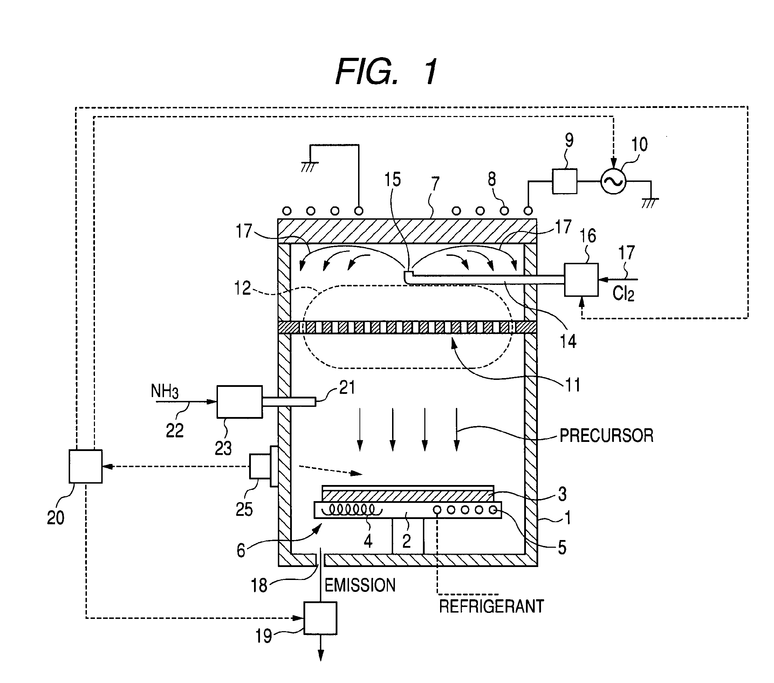

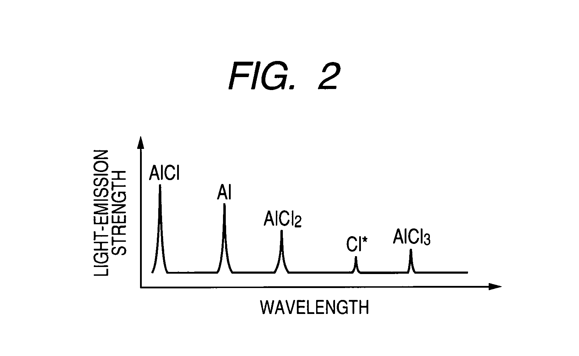

FIG. 1 illustrates a schematic side view of a thin-film producing apparatus according to one embodiment of the present invention; and FIG. 2 shows a graph showing a light-emitting state of plasma.
As is illustrated in FIG. 1, a support table 2 is provided in the vicinity of the bottom part of a chamber 1, for instance, made from a ceramic (made from insulation material), which has been formed to be a cylindrical shape, and a substrate 3 is mounted on the support table 2. Temperature control means 6 which includes a heater 4 and refrigerant circulating means 5 is provided on the support table 2, and the support table 2 is controlled to a predetermined temperature (such temperature that substrate 3 is kept at 100°C to 300°C, for instance) by the temperature control means 6. Incidentally, the shape of the chamber is not limited to the cylindrical shape, but the chamber can employ, for instance, a rectangular shape as well.
The upper face of the chamber 1 is formed to be an opening portion, and the opening portion is blocked with a tabular ceiling board 7 made from an insulation material (made from ceramic, for instance). A plasma antenna 8 for forming a plasma state in the inside of the chamber 1 is provided above the ceiling board 7, and the plasma antenna 8 is formed to be a planar ring shape parallel to the plane of the ceiling board 7. A matching box 9 and a power source 10 are connected to the plasma antenna 8, and feed a high-frequency power thereto. Plasma generating means for generating an induction plasma is constituted by the plasma antenna 8, the matching box 9 and the power source 10.
An etching object member (member to be etched) 11 made from aluminum (Al) is held by the chamber 1, and is arranged in between the substrate 3 and the ceiling board 7 in a discontinuous state with respect to an electric flow of the plasma antenna 8. The etching object member 11 is formed, for instance, to be a grid shape and in a structurally discontinuous state with respect to the peripheral direction which is the direction of the electric flow of the plasma antenna 8.
As for a configuration of the etching object member which is set at a discontinuous state with respect to the electric flow of the plasma antenna 8, it is also possible to form the etching object member into a mesh shape, or to form a plurality of long protrusions in the inner peripheral side of the ring.
One line of a gas nozzle 14 for feeding an action gas 17 containing chlorine as a halogen (gas: $Cl_2$ gas diluted to predetermined concentration by He) into the inner part of the chamber 1 is provided in a cylinder portion of the chamber 1 above the etching object member 11. The gas nozzle 14 extends to the central part of the chamber 1, and the tip is directed toward the upside and is made to be a gas blow hole 15. Gases of He and $Cl_2$ are individually controlled and sent to a flow rate controller 16, and $Cl_2$ action gas 17 which has been diluted by He is sent to the gas nozzle 14 through the flow rate controller 16 which controls the flow rate and the pressure (action gas feeding means).
The shape and the arrangement of the gas nozzle 14 is not limited to the illustrated example, but for instance, a plurality of gas nozzles may be connected in the peripheral direction of the chamber 1 at equal spaces (on eight spots, for instance). Fluorine, bromine, iodine or the like can be applied to the halogen contained in the action gas. By using chlorine as the halogen, the thin film can be produced with the use of inexpensive chlorine gas.
In addition, a nozzle 21 for feeding ammonia ($NH_3$) is provided on the cylinder portion of the chamber 1, and $NH_3$ is fed into the chamber 1 from the nozzle 21 through a flow rate controller 23. The $NH_3$ which has been fed into the chamber is disassociated to $NH_2$ and a hydrogen radical $H^*$ by plasma, and $NH_2$ is formed (forming means), which will be described later. Alternatively, $NH_3$ is converted into $NH_2$ and HCl through a reaction with a chlorine radical $Cl^*$, and $NH_2$ is formed (forming means).
A gas or the like, which does not participate in a film-forming process, is emitted (exhausted) from a vent 18. The inside of the chamber 1 which has been sealed with the ceiling board 7 is kept at a predetermined pressure by a vacuum unit 19. An unshown valve of the vacuum unit 19 is controlled by control means 20, and the inside of the chamber is controlled to a desired pressure through adjustment by the valve. On the other hand, the control means 20 appropriately adjusts the output of the power source 10, and consequently can control an RF power.

In addition, a plasma spectroscope 25 for detecting a light-emitting state of plasma (light-emission strength with respect to wavelength, for instance) is provided on the cylinder portion of the chamber 1, determines the states (spectroscopic data) of the chlorine radical $Cl^*$, $AlX_3$, $AlX_2$ and $AlX$, which will be described later, based on the spectroscopic data, and sends the spectroscopic data to the control means 20. The control means 20 appropriately controls the flow rate of an action gas 17 and the flow rate of $NH_3$ based on the sent spectroscopic data.

The above described thin-film producing apparatus feeds the action gas 17 containing chlorine into the chamber 1, controls (prolongs) the staying period of the fluid, specifically, increases the pressure in the chamber 1, makes the chlorine radical etch the etching object member 11 containing Al to form a precursor $AlCl_3$ including an Al component contained in the etching object member and the halogen Cl, and simultaneously forms $AlCl_2$ and (or) $AlCl$ of intermediate products. The thin-film producing apparatus also feeds $NH_3$ into the chamber 1 from the nozzle 21, and forms $NH_2$ by plasma or through a reaction with the chlorine radical $Cl^*$; and then deposits an AlN component on the substrate 3 side through a reaction of $AlCl_2$ ($AlCl$) with $NH_2$ (and chlorine radical $Cl^*$).

The intermediate product of $AlCl_2$ ($AlCl$) is formed by prolong the staying period of the fluid, and the intermediate product is made to react with $NH_2$ (and chlorine radical $Cl^*$), and as a result, the Al component of the precursor $AlX_3$ is deposited on the substrate 3 side as AlN. Accordingly, a reduction by the Cl radical can be facilitated, and a thin film of AlN can be unfailingly produced.

Here, the staying period of the fluid is controlled by increasing the pressure in the chamber 1. The staying period (t) of the fluid is expressed by

$$t = V/QTP.$$

Here, Q represents a flow rate of gas, T represents a temperature in the atmosphere, P represents a pressure (760 (Torr) /P (Total)), and V represents a volume in the reaction atmosphere. Accordingly, prolonging the staying period of the fluid, by which the intermediate products of $AlCl_2$ and $AlCl$ is formed, can be attained by any of operations of: raising the pressure P (Total: Torr) to decrease the P to a small value; reducing the flow rate; lowering the temperature; and increasing the volume. In the present embodiment, in consideration of the controllability or the like, the staying period is prolonged by raising the pressure P (Total: Torr).

When a metal thin film is produced by using a new type of a CVD apparatus, the pressure P (Total: Torr) is set in a range of 0.1 to 0.2 (Torr), but in the present embodiment, the pressure P (Total: Torr) is set, for instance, in a range of 0.5 to 1.0 (Torr), and the staying period is set at approximately 1.5 times longer. The pressure P is set by the control of an unshown valve of the vacuum unit 19.

The specific film-forming (deposition) state will now be described below.

The action gas 17 is fed to the inner part of the chamber 1, which has been controlled to 0.5 to 1.0 (Torr), from a gas nozzle 14. A plasma antenna 8 projects an electromagnetic wave to the inside of the chamber 1, ionizes the action gas 17 to generate a plasma of the $Cl_2$ gas, and forms Cl radicals. The plasma is generated in a region illustrated by gas plasma 12. The reaction at this time can be expressed by the following formula:

$$Cl_2 \rightarrow 2Cl^*$$

, wherein $Cl^*$ represents a chlorine radical.

The gas plasma 12 acts on an etching object member 11 containing Al to heat the etching object member 11 and simultaneously cause an etching reaction on Al. The reaction at this time can be expressed, for instance, by the following formula.

$$AlCl_3 \rightarrow AlCl_2 \rightarrow AlCl$$

The chlorine radical $Cl^*$ acts on $AlCl_3$, thereby causes the reaction of:

$$AlCl_3+Cl^* \rightarrow AlCl_2+Cl_2\uparrow, \text{ and forms } AlCl_2 \text{ (control means)}.$$

The chlorine radical $Cl^*$ also acts on $AlCl_2$, thereby causes the reaction of:

$$AlCl_2+Cl^* \rightarrow AlCl+Cl_2\uparrow, \text{ and forms } AlCl \text{ (control means)}.$$

The thin-film producing apparatus also feeds ammonia ($NH_3$) into the inside of the chamber 1 from the nozzle 21. $NH_3$ causes the reaction of:

$$NH_3 \rightarrow NH_2+H^*$$

by gas plasma 12, that is to say, $NH_3$ is dissociated into $NH_2$ and a hydrogen radical $H^*$, and $NH_2$ is formed.
$NH_3$ causes the reaction of:

$$NH_3+Cl^* \rightarrow NH_2+HCl\uparrow$$

by the chlorine radical $Cl^*$, that is to say, is dissociated into $NH_2$ and HCl, and $NH_2$ is formed.
The formed $NH_2$ and $AlCl_2$ cause the reaction of:

$$AlCl_2+NH_2 \rightarrow AlN+2HCl\uparrow$$

to deposit the AlN component on the substrate 3.
In addition, $AlCl_2$, formed $NH_2$, AlCl and the chlorine radical $Cl^*$ cause the reaction of:

$$AlCl+NH_2+Cl^* \rightarrow AlN+2HCl\uparrow$$

to deposit the AlN component on the substrate 3.
In this way, the thin-film producing apparatus makes the Al component of a precursor $AlX_3$ react with $NH_2$ through easily reducible (unstable) intermediate products to form a film of AlN on a substrate 3 side, and can unfailingly produce a thin film of AlN at low temperatures.
Incidentally, in the above described embodiment, the thin-film producing apparatus feeds ammonia ($NH_3$) into the inside of the chamber 1 and produces the thin film of AlN, but can independently feed $H_2$ and $N_2$ and produces the thin film of AlN. In this case, it is necessary to optimally set a temperature condition or the like.
When the above described thin film of Al is produced, a plasma spectroscope 25 detects a light-emitting state of plasma (light-emission strength with respect to wavelength, for instance) in the film-forming process (deposition process). Specifically, the light-emission strengths of $AlCl_3$, $AlCl_2$, AlCl, the chlorine radical $Cl^*$ and Al are different according to the wavelengths, as is illustrated in FIG. 2, and accordingly the plasma spectroscope 25 can detect the states of $AlCl_3$, $AlCl_2$, AlCl, the chlorine radical $Cl^*$ and Al by detecting the light-emission strengths.
The detected data by the plasma spectroscope 25 is sent to control means 20, and the control means 20 monitors whether $AlCl_3$, $AlCl_2$, AlCl, the chlorine radical $Cl^*$ and Al are formed in a desired state through the above described reaction process. When the desired product has not been obtained (when the state of light-emission strengths does not match with a previously memorized state) as a result of monitoring, the control means 20 commands a vacuum unit 19 to adjust an unshown valve and control the pressure so that $AlCl_3$, $AlCl_2$, AlCl, the chlorine radical $Cl^*$ and Al can be formed in the desired state.

Such a flow rate of ammonia (NH$_3$) as to match with states of AlCl$_2$ and AlCl is determined on the basis of the result of monitoring, and the flow rate of ammonia (NH$_3$) is controlled by commands on the flow rate adjustment sent to a flow rate controller 23.

The above described AlCl forms an Al component through the reaction of:

$$\text{AlCl+Cl}^* \;\rightarrow\; \text{Al+Cl}_2\!\uparrow, \text{ which is caused by the}$$

$$\text{chlorine radical Cl}^*.$$

In addition, the AlCl$_2$ forms the Al component through the reaction of:

$$\text{AlCl}_2\text{+AlCl}_2 \;\rightarrow\; \text{2Al}\!\downarrow\text{+Cl}_2\!\uparrow, \text{ which is caused in the}$$

$$\text{plasma.}$$

The thin-film producing apparatus repeats the feed and stop of ammonia (NH$_3$) on the basis of the detected data by the plasma spectroscope 25, thereby makes the above described reaction and a formation reaction of AlN alternately conducted, and can produce a stacked film of Al and AlN on a substrate 3.

It is also possible at this time to produce a thin film in a state in which the compositions of Al and AlN are inclined on the substrate 3, by controlling the flow rate of ammonia (NH$_3$). Furthermore, it is also possible to produce a stacked film of Al and AlN on the substrate 3 on which Al$_2$O$_3$ has been produced beforehand. In this case, the stacked film can be used as a gate metal having a high dielectric constant.

By the way, when the pressure is raised, the chlorine radical Cl$^*$ decreases, which may cause an unequal balance with AlCl$_x$. When a plasma density is increased, the chlorine radical Cl$^*$ and AlCl$_x$ increase, so that control means 20 appropriately adjusts the output of a power source 10 to increase an RF power in synchronization with an action of raising the pressure, and thereby can increase the plasma density. The operation increases the chlorine radical Cl$^*$, eliminates the possibility of decreasing the chlorine radical Cl$^*$ even when having raised the pressure, and can keep the balance with AlCl$_x$.

Incidentally, as for a configuration of increasing the chlorine radical Cl$^*$, a configuration of separately feeding the chlorine radical Cl$^*$ may be adopted other than a method of raising the RF power.

When the thin film of AlN has been produced, it is considered that the thin film is etched by the chlorine radical Cl$^*$ when the temperature of the substrate 3 side is kept high. In order to inhibit the thin film from being etched, the thin-film producing apparatus feeds Ar gas into the chamber 1 when having finished the film formation, generates plasma, thereby lowers an electron temperature in the vicinity of the substrate 3. These processes allow to reduce a radiant energy of the surface of the substrate.

Furthermore, it is considered that the thin film of AlN is affected by the Cl radical Cl$^*$ which remains after the plasma has been stopped. In order to inhibit the thin film of AlN from being affected, the thin-film producing apparatus continuously passes He after the plasma has been stopped, makes the He react with the Cl radical Cl$^*$, and can exhaust the resultant gas as Cl$_2$ gas. Thereby, the formed thin film of AlN is not affected by the remaining Cl radical Cl$^*$.

Accordingly, the present invention can provide a thin-film producing apparatus that employs a new type of a CVD apparatus and can unfailingly produce a thin film of AlN at low temperatures, and a method of producing the thin film.

**INDUSTRIAL APPLICABILITY**

The present invention can be used in industrial fields of a thin-film producing apparatus which can form a thin film of AlN, and of a method of producing the thin film.

**Claims**

**1.** A thin-film producing apparatus comprising:

a chamber configured to accommodate a substrate therein;
an etching object member containing Al configured to provide at a position opposing to the substrate in the chamber;

action gas feeding means for feeding an action gas containing a halogen into the inside of the chamber;

a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;

forming means for forming $NH_2$ which is a compound of nitrogen and hydrogen, in the inner part of the chamber; and

a controlling means for generating a intermediate product of $AlX_2$ from the precursor $AlX_3$ by lowering temperature of the substrate side less than temperature of the etching object member and simultaneously controlling the staying period of fluid, and forming AlN component generated from reaction of the $NH_2$ generated by the forming means and the $AlX_2$, on the substrate side.

2.  A thin-film producing apparatus comprising:

a chamber configured to accommodate a substrate therein;

an etching object member containing Al configured to provide at a position opposing to the substrate in the chamber;

action gas feeding means for feeding an action gas containing a halogen into the inside of the chamber;

a plasma generating means for generating a plasma of the action gas by generating plasma within the chamber to generate a halogen radical, and generating a precursor $AlX_3$ formed by Al component contained in the etching object member and halogen X by controlling a staying period of a fluid to etch the etching object member with the halogen radical;

forming means for forming $NH_2$ which is a compound of nitrogen and hydrogen, in the inner part of the chamber; and

a controlling means for generating a intermediate product of AlX from the precursor $AlX_3$ by lowering temperature of the substrate side less than temperature of the etching object member and simultaneously controlling the staying period of fluid, and forming AlN component generated from reaction of the $NH_2$ generated by the forming means, the AlX, and the halogen radical, on the substrate side.

3.  The thin-film producing apparatus according to claim 1, wherein
the forming means has a function of making ammonia ($NH_3$) react with the halogen radical to form $NH_2$.

4.  The thin-film producing apparatus according to claim 1, wherein
the forming means has a function of converting ammonia ($NH_3$) into $NH_2$ and a H radical in the plasma to form $NH_2$.

5.  The thin-film producing apparatus according to claim 1, wherein
the forming means has a function of causing a dissociation reaction between hydrogen and nitrogen thereby to form $NH_2$.

6.  The thin-film producing apparatus according to claim 1, wherein
the forming means includes a function of adjusting an amount of $NH_2$ according to a state of the precursor $AlX_3$, and the control means includes a function of adjusting an amount of $NH_2$ to a desired state to make the Al component and the AlN component intermixed on the substrate.

7.  The thin-film producing apparatus according to claim 6, wherein
the function of the control means for making the Al component and the AlN component intermixed is a function of alternately stacking the Al component and the AlN component on each other.

8.  The thin-film producing apparatus according to claim 1, wherein
the staying period is derived from a value calculated by dividing the volume of the chamber by a product of a flow rate of the action gas, a temperature in the atmosphere and a pressure in the chamber, and
the plasma generating means and the control means control the staying period by increasing the pressure in the chamber.

9.  The thin-film producing apparatus according to claim 1, wherein
the halogen contained in the action gas is chlorine.

**10.** A method of producing a thin film comprising:

forming NH$_2$ which is a compound of nitrogen and hydrogen, while feeding an action gas containing a halogen into a chamber; etching an etching object member containing Al with a halogen radical by controlling a staying period of a fluid to form a precursor AlX$_3$ formed by an Al component contained in the etching object member and the halogen X; and forming an AlN component which has been produced through a reaction of NH$_2$ with AlX$_2$ on a substrate side, while producing an intermediate product of AlX$_2$ from the precursor AlX$_3$.

**11.** A method of producing a thin film comprising:

forming NH$_2$ which is a compound of nitrogen and hydrogen, while feeding an action gas containing a halogen into a chamber; etching an etching object member containing Al with a halogen radical by controlling a staying period of a fluid to form a precursor AlX$_3$ formed by an Al component contained in the etching object member and the halogen X; and forming an AlN component which has been produced through a reaction of NH$_2$ with AlX$_2$ and the halogen radical on a substrate side, while producing an intermediate product of AlX$_2$ from the precursor AlX$_3$.

**12.** The method of producing the thin film according to claim 10, wherein
NH$_2$ is formed by making ammonia (NH$_3$) react with the halogen radical.

**13.** The method of producing the thin film according to claim 10, wherein
NH$_2$ is formed by converting ammonia (NH$_3$) into NH$_2$ and a H radical in plasma.

**14.** The method of producing the thin film according to claim 10, wherein
NH$_2$ is formed by causing a dissociation reaction between hydrogen and nitrogen.

**15.** The method of producing the thin film according to claim 10, wherein
the thin film is produced on by adjusting an amount of NH$_2$ according to a state of the precursor AlX$_3$ to make the Al component and the AlN component intermixed in a substrate.

**16.** The method of producing the thin film according to claim 15, wherein
the thin film in which the Al component and the AlN component are alternately stacked on each other is produced, by making the Al component and the AlN component intermixed.

**17.** The method of producing the thin film according to claim 15, wherein
the thin film in which the AlN component and the Al component are stacked on each other is produced on the substrate on which the thin film of Al$_2$O$_3$ has been produced, by making the Al component and the AlN component intermixed.

**18.** The method of producing the thin film according to claim 10, wherein
the halogen contained in the action gas is chlorine.

# FIG. 1

EP 2 196 558 A1

# FIG. 2

**INTERNATIONAL SEARCH REPORT**

| International application No. |
| --- |
| PCT/JP2006/317335 |

A. CLASSIFICATION OF SUBJECT MATTER
*C23C16/34*(2006.01)i, *H01L21/203*(2006.01)i, *H01L21/318*(2006.01)i

According to International Patent Classification (IPC) or to both national classification and IPC

B. FIELDS SEARCHED

Minimum documentation searched (classification system followed by classification symbols)
C23C16/00-16/56, H01L21/203, H01L21/318

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2003-152059 A  (Mitsubishi Heavy Industries, Ltd.), 23 May, 2003 (23.05.03), Par. Nos. [0020] to [0027] (Family: none) | 1-18 |
| Y | JP 2003-119565 A  (Mitsubishi Heavy Industries, Ltd.), 23 April, 2003 (23.04.03), Par. Nos. [0032] to [0034] & US 2003/0031791 A1    & EP 1284305 A3 | 1-18 |
| Y | JP 2003-247071 A  (Mitsubishi Heavy Industries, Ltd.), 05 September, 2003 (05.09.03), Par. Nos. [0034] to [0035] & US 2003/0091739 A1 | 1-18 |

☐ Further documents are listed in the continuation of Box C.       ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 11 October, 2006 (11.10.06) | Date of mailing of the international search report 24 October, 2006 (24.10.06) |
| --- | --- |
| Name and mailing address of the ISA/ Japanese Patent Office | Authorized officer |
| Facsimile No. | Telephone No. |

Form PCT/ISA/210 (second sheet) (April 2005)

**EP 2 196 558 A1**

## REFERENCES CITED IN THE DESCRIPTION

**Patent documents cited in the description**

- JP 2003147534 A